# EUROPÄISCHE PATENTSCHRIFT

(11) **EP 2 211 465 B1**
(45) Veröffentlichungstag und Bekanntmachung des Hinweises auf die Patenterteilung: **28.11.2012**
(21) Anmeldenummer: 09015415.4
(22) Anmeldetag: 14.12.2009
(51) Int. Cl.: H03K 17/96, H03K 17/965

(54) **Bedieneinrichtung für ein Elektrogerät**
Operating device for an electric device
Dispositif de commande d'un appareil électrique

(30) Priorität: 22.01.2009 DE 102009006421
(43) Veröffentlichungstag der Anmeldung: 28.07.2010
(73) Patentinhaber: E.G.O. Elektro-Gerätebau GmbH, 75038 Oberderdingen (DE)
(72) Erfinder: Hamm, Wolfgang Alfred, Dr., 75015 Bretten (DE)
(74) Vertreter: Patentanwälte Ruff, Wilhelm, Beier, Dauster & Partner

(56) Entgegenhaltungen:
- EP-A2- 1 775 650
- EP-A2- 1 923 999
- WO-A2-2005/019766
- DE-U1-202006 006 509
- US-B1- 6 410 866

## Beschreibung

### Anwendungsgebiet und Stand der Technik

Die Erfindung betrifft eine Bedieneinrichtung für ein Elektrogerät gemäß dem Oberbegriff des Anspruchs 1.

Derartige Bedieneinrichtungen sind in vielfältiger Form bekannt. Ganz überwiegend sind hier, wie beispielsweise aus der EP 1 318 534 A1 bekannt ist, Aufnahmen an einer oder hinter einer Bedienblende angeordnet, in denen ein Bedienelement, wie beispielsweise ein Drehknebel, gelagert ist. Dieser Drehknebel kann auch versenkbar sein. Hinten an der Aufnahme ist ein Dreh-Schaltgerät angeordnet, welches über den Drehknebel bedient wird. Es kann wünschenswert sein, dass zusätzlich zu einer solchen Betätigung durch Drehung weitere Funktionen mit der Bedieneinrichtung ausgelöst werden können. Es können beispielsweise Zusatzschalter odgl. vorgesehen sein. Eine Möglichkeit, derartige Zusatzschalter an einem Drehknebel selber auszubilden, sind beispielsweise aus der EP 1 775 650 A1 bekannt.

Die DE 20 2006 006 509 U1 beschreibt einen Dimmer als Bedieneinrichtung mit einem drehbaren Stellknopf und einer den Stellknopf umgebenden eckigen Frontplatte. An der Frontplatte, insbesondere in einer der Ecken, ist ein Berührungsschalter angeordnet. Dieser ist nach hinten kontaktiert.

### Aufgabe und Lösung

Der Erfindung liegt die Aufgabe zugrunde, eine eingangs genannte Bedieneinrichtung zu schaffen, die weitere Funktionen aufweist sowie mit der vorteilhaft eine Erweiterung der Bedienfunktionalität der Bedieneinrichtung erreicht werden kann.

Gelöst wird diese Aufgabe durch eine Bedieneinrichtung mit den Merkmalen des Anspruchs 1. Vorteilhafte sowie bevorzugte Ausgestaltungen der Erfindung sind Gegenstand der weiteren Ansprüche und werden im Folgenden näher erläutert. Der Wortlaut der Ansprüche wird durch ausdrückliche Bezugnahme zum Inhalt der Beschreibung gemacht.

Es ist vorgesehen, dass die Bedieneinrichtung ein Bedienelement zur Bedienung durch Drehbetätigung aufweist, insbesondere einen Drehknebel. Das Bedienelement ist in der Bedienblende angeordnet, wobei es dabei in einer topfartigen Aufnahme gelagert ist. Erfindungsgemäß ist in einem Bereich in der Bedienblende nahe an dem Bedienelement bzw. um das Bedienelement herum mindestens ein zusätzlicher Berührungsschalter vorgesehen. Insbesondere grenzt dieser Berührungsschalter direkt an das Bedienelement an bzw. ist nur durch einen schmalen Passungsspalt davon getrennt.

Somit ist es möglich, dass durch das drehbare Bedienelement beispielsweise Leistungsstufen oder Zeiten eingestellt werden können, also Zahlenwerte verändert werden können. Diese sind dann nach Abschluss der Einstellung gültig, alternativ kann eben gerade über einen zusätzlichen Berührungsschalter ein Signal als Bestätigungssignal erzeugt werden. Des Weiteren kann durch eine Drehbetätigung eine räumliche Zuordnung durch beispielsweise eine Einstellungsmarkierung am Bedienelement an einem von mehreren, ringartig um das Bedienelement herum angeordneten Berührungsschalter erfolgen, und dann diese betätigt werden als Bestätigungssignal. Zahlreiche weitere Möglichkeiten für Bedienverfahren sind gegeben und leicht vorstellbar.

In Ausgestaltung der Erfindung kann vorteilhaft vorgesehen sein, dass der Berührungsschalter ein kapazitiver Berührungsschalter ist. Dazu kann er ein elektrisch leitfähiges kapazitives Sensorelement aufweisen. Dieses Sensorelement ist besonders vorteilhaft nach außen bzw. an der Vorderseite der Bedienblende, wo es angeordnet ist, elektrisch isoliert. Dies bedeutet also, dass es gegenüber der Berührung durch eine Bedienperson elektrisch isoliert ist und somit auch Sicherheitsbestimmungen eingehalten werden.

In Weiterbildung der Erfindung kann vorgesehen sein, dass die Aufnahme einen kragenartigen Abschnitt aufweist, der etwa parallel zu der Bedienblende und um das Bedienelement herum verläuft. An diesem kragenartigen Abschnitt kann ein Berührungsschalter bzw. ein Sensorelement dafür angeordnet und beispielsweise daran befestigt sein. Darauf wird nachfolgend noch genauer eingegangen. Insbesondere kann vorgesehen sein, dass der kragenartige Abschnitt der Aufnahme den Berührungsschalter bzw. das Sensorelement überdeckt. Dann kann beispielsweise auch sehr gut die vorgenannte elektrische Isolierung erreicht werden. Eine Berührfläche des Berührungsschalters wird dann durch den Abschnitt der Aufnahme gebildet, so dass an der Blende keine aufwändigen Arbeiten vorzunehmen sind bzw. bei gleicher Blende durch Variation der Bedieneinrichtung eine Variation des Designs und/oder der Bedienfunktionen erreicht werden kann.

In einer Ausgestaltung der Erfindung ist es möglich, das Sensorelement, das vorteilhaft flächig ausgebildet ist, als Beschichtung herzustellen. Eine solche Beschichtung aus elektrisch leitfähigem Material kann vorteilhaft auf einem Bereich der Aufnahme erfolgen, der parallel zur Bedienblende verläuft. Insbesondere ist dies der vorgenannte kragenartige Abschnitt, an dessen Rückseite dann die Sensorelemente durch entsprechende Beschichtung aufgebracht werden.

In alternativer Ausgestaltung der Erfindung kann vorgesehen sein, dass ein Sensorelement aus Flachmaterial hergestellt wird, vorteilhaft als flaches Metallplättchen. Ein solches Metallplättchen kann als separates Teil an der Bedienblende selbst oder der Aufnahme befestigt werden, beispielsweise aufgeklebt. Auch hier bietet es sich an, ein solches Sensorelement als separates Teil an der Aufnahme bzw. dem vorgenannten kragenartigen Abschnitt zu befestigen, ähnlich wie die Beschichtung. Dadurch wird auch gewährleistet, dass die Sensorelemente in genau vorgegebener räumlicher Zuordnung zu der Bedieneinrichtung angeordnet sind.

Bei der Erfindung ist eine elektrische Zuleitung bzw. Verbindung zu den Berührungsschaltern bzw. dessen Sensorelementen in die Aufnahme integriert. Dazu ist die Aufnahme in einem Durchbruch in der Bedienblende angeordnet und weist beispielsweise ein mittels des Bedienelements durch Drehbetätigung betätigbares Schaltgerät auf, das an einem hinteren Ende der Aufnahme befestigt ist.

Eine elektrische Zuleitung bzw. Verbindung ist derart in die Aufnahme integriert, dass sie als elektrische leitfähige Beschichtung auf einer Oberfläche der Aufnahme vorgesehen ist. Dies ist besonders vorteilhaft an der Außenseite der Aufnahme möglich. Eine Beschichtung kann durch eine Dickschichtpaste odgl. erfolgen, alternativ durch Kunststoffe, denen Partikel beigemischt sind für eine elektrische Leitfähigkeit. Alternativ zu einer Beschichtung kann eine elektrische Zuleitung bzw. Verbindung durch sehr dünne elektrische Leiter erreicht werden, die beispielsweise aus sehr dünnen Kupferstreifen bestehen und auf die Aufnahme aufgeklebt werden. Als eine nochmals weitere Ausgestaltung der Erfindung kann als Alternative eine elektrische Zuleitung bzw. Verbindung als eine Art Leiterdraht odgl. in eine Aufnahme, die üblicherweise aus Kunststoff besteht, eingespritzt werden. Durch Zwei-Komponentenspritzen können auch elektrische leitfähige Kunststoffe als elektrische Zuleitung eingespritzt werden.

Allgemein können sowohl Sensorelemente als auch elektrische Zuleitungen bzw. Verbindungen in MID-Technologie (Molded Interconnect Devices) aufgebracht werden. Dies ist eine neuartige Methode, bei der auf dreidimensional geformten Trägern wie eben hier der Aufnahme ein Leiterbild in Form einer strukturierten Metallschicht aufgebracht wird.

Bei der elektrischen Zuleitung in Form einer Beschichtung kann vorgesehen sein, dass diese an der Außenseite der Aufnahme zu dem genannten kragenartigen Abschnitt geführt sind und sich über diesen erstrecken. Entweder kann eine solche Beschichtung an sich bereits, wenn sie flächig aufgebracht ist, ein sogenanntes kapazitives Sensorelement bilden. Alternativ kann vor allem ein Sensorelement in Form eines Metallplättchens auf sie aufgelegt und aufgeklebt werden, insbesondere mit Leitkleber, für eine elektrische Verbindung. Dies geht dann entsprechend auch mit den vorbeschriebenen aufgebrachten dünnen Leitern aus beispielsweise dünnem Kupferblech odgl..

Mittels der genannten elektrischen Zuleitung bzw. Verbindung wird vorteilhaft eine elektrische Verbindung zu einem an dem hinteren Ende der Aufnahme angeordneten, vorbeschriebenen Schaltgerät vorgesehen. Somit ist es möglich, einen elektrischen Anschluss des Berührungsschalters am Schaltgerät vorzusehen, beispielsweise auf ähnliche Art und Weise wie elektrische Anschlüsse an das Schaltgerät selbst. Dadurch können beispielsweise gleiche Stecker wie Gruppenstecker odgl. verwendet werden. Jedenfalls sind dann die elektrischen Anschlüsse sehr schnell und deutlich erkennbar. Als Alternative kann ein separates Kabel von der Zuleitung bzw. Verbindung weggeführt werden für einen elektrischen Anschluss.

In vorteilhafter Weiterbildung der Erfindung sind, wie zuvor angesprochen worden ist, mehrere zusätzliche Berührungsschalter an der Bedienblende vorgesehen und um das Bedienelement herum verteilt. Dabei können sie besonders vorteilhaft gleich groß ausgebildet sein und gleich verteilt sein. Hier ist vorteilhaft vorgesehen, dass für jeden separaten Berührungsschalter bzw. dessen vorgenanntes Sensorelement eine separate elektrische Zuleitung bzw. Verbindung vorgesehen ist mit separatem elektrischen Anschluss. So können beispielsweise vier bis zwölf derartige Sensorelemente vorgesehen sein.

In weiterer Ausgestaltung der Erfindung kann um das Bedienelement herum an der Bedienblende eine Anzeige vorgesehen sein. Dies kann beispielsweise eine LED- bzw. OLED-Anzeige sein, die auch jeweils unterschiedlich angesteuert werden kann. Eine elektrische Ansteuerung einer solchen Anzeige kann auf ähnliche Art und Weise erfolgen für die genannten Berührungsschalter bzw. Sensorelemente.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine Schnittdarstellung durch eine erfindungsgemäße Bedieneinrichtung mit ausgefahrenem Drehknebel und Sensorelementen,
- Fig. 2: eine Draufsicht auf die Bedieneinrichtung aus Fig. 1 mit den mehreren, ringartig angeordneten Berührungsschaltern und
- Fig. 3: eine Seitenansicht der Bedieneinrichtung aus Fig. 1.

### Detaillierte Beschreibung der Ausführungsbeispiele

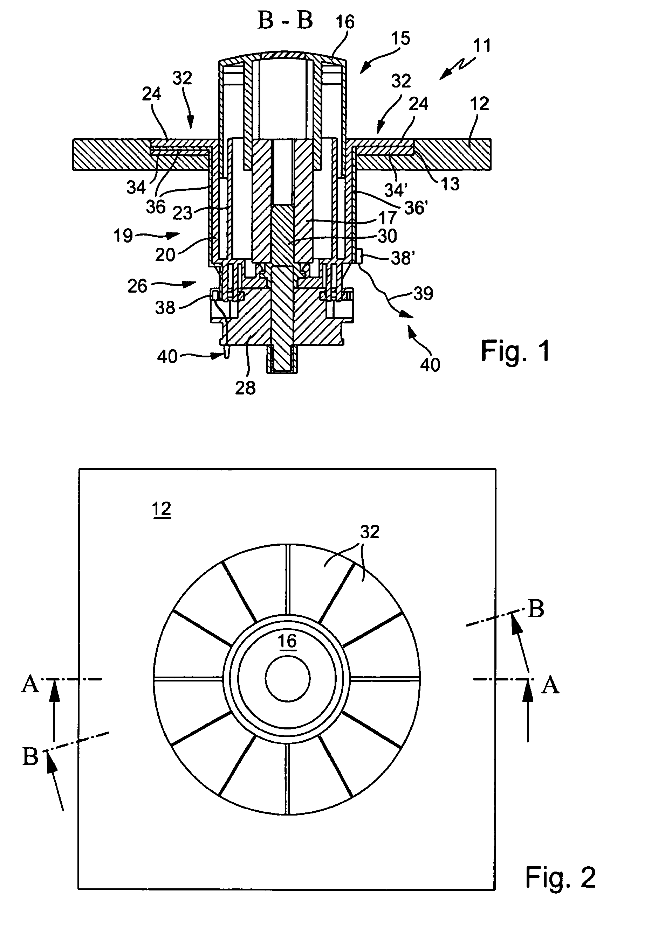

In Fig. 1 ist im Schnitt B-B nach Fig. 2 eine erfindungsgemäße Bedieneinrichtung 11 dargestellt, die an einer Bedienblende 12 eines nicht weiter dargestellten Elektrogerätes montiert ist, und zwar in einem Ausschnitt 13, in dem die Bedieneinrichtung 11 bündig sitzt. Sie weist zur Drehbetätigung einen Drehknebel 15 auf, der aus einem vorderen Greifteil 16 und einem als Lagerund ausgebildeten Basisteil 17 besteht. Die Verbindung von Greifteil 16 und Basisteil 17 ist so, dass der Drehknebel 15 als Versenk-Drehknebel ausgebildet ist. Dies ist beispielsweise aus der EP 1 318 534 A1 bekannt, so dass es nicht weiter erläutert werden muss.

Der Drehknebel 15 verläuft in einem Aufnahmetopf 19. Der Aufnahmetopf 19 weist einen Außenmantel 20 auf, vorteilhaft als rohrartiger Abschnitt, sowie einen damit direkt verbundenen Innenmantel 23. In den Zwischenraum zwischen Innenmantel 23 und Außenmantel 20 kann beim Versenken der Greifteil 16 des Drehknebels 15 eingreifen. Nach vorne zu geht der Außenmantel 20 in einen kragenartigen Abschnitt 24 über, wobei der Abschnitt 24 etwa rechtwinklig von der Längserstreckung des Außenmantels 20 absteht. Dies kann auch ganz gut aus der Fig. 2 mit der Draufsicht ersehen werden.

Am rückseitigen Ende 26 des Aufnahmetopfes 19 ist ein Dreh-Schaltgerät 28 vorgesehen, das mit dem Drehknebel 15 eingestellt werden kann. Dazu ist es über einen Achsstummel 30, der am rückseitigen Ende 26 des Aufnahmetopfes 19 gelagert wird, mit dem Basisteil 17 verbunden.

An der Vorderseite bzw. an der Bedienblende 12 sind Berührungsschalter 32 vorgesehen, wie vor allem die Fig. 2 zeigt, und zwar zwölf Stück rings um den Drehknebel 15 verteilt. Die Berührungsschalter 32 sind durch trennende Stege klar voneinander abgegrenzt. Sie sind als kapazitive Berührungsschalter ausgebildet und weisen dazu kapazitive Sensorelemente 34 auf. In der Darstellung links in Fig. 1 ist ein kapazitives Sensorelement 34 als entsprechend geformtes Metallplättchen ausgebildet und an der nach hinten weisenden Seite des kragenartigen Abschnitts 24 befestigt, insbesondere festgeklebt. An der elektrischen Kontaktierung des Sensorelements 34 ist eine elektrische Zuleitung 36 vorgesehen, die auf der Außenseite des Außenmantels 20 angebracht ist, entweder als elektrisch leitfähige Beschichtung oder in Bahnform aufgeklebtes Leitermaterial. Die elektrische Zuleitung 36 bedeckt die gesamte rückseitige Fläche des kragenartigen Abschnitts 24 mit der Kontur des Sensorelementes 34 und liegt an diesem an bzw. ist mit diesem elektrisch verbunden. Dann läuft die elektrische Zuleitung 36 auf das rückseitige Ende 26 zu, und zwar stets auf der Oberfläche der Außenseite des Außenmantels 20. Mittels einer Kontaktierung 38, beispielsweise aufgeklebt mit Leitkleber, und einem Kabel odgl., ist sie mit einem Anschlussstecker 40 an die Unterseite des Dreh-Schaltgeräts 28 verbunden bzw. daran angeschlossen. Über das Aufstecken eines entsprechend geeigneten Steckers ist das kapazitive Sensorelement 34 ansteuerbar sowie auswertbar.

Alternativ zu einem kapazitiv arbeitenden Berührungsschalter könnte eine Miniatur-Reflexionslichtschranke verwendet werden, um das Auflegen eines Fingers eines Bedieners zu erkennen. Diese ist dann anstelle des Sensorelements 34 unter dem kragenartigen Abschnitts 24 angeordnet und wird über entsprechende elektrische Verbindungen angesteuert. Dabei ist allerdings der Anschlussaufwand deutlich höher.

Rechts in Fig. 1 ist eine alternative Ausbildung dargestellt. Auch dort ist ein Berührungsschalter 32 vorgesehen, zu dessen Betätigung eine Bedienperson ihren Finger auf den Berührungsschalter 32 bzw. die Oberseite des kragenartigen Abschnitts 24 an dieser Stelle legt. Hier ist an der Unterseite des kragenartigen Abschnitts 24 ein kapazitives Sensorelement 34' vorgesehen, welches als Beschichtung ausgebildet ist und nicht als separates Teil wie das Sensorelement 34. Diese Beschichtung ist direkt mit einer elektrischen Zuleitung 36' verbunden, welche wie vorbeschrieben einerseits eine Beschichtung und andererseits ein separater Leiter sein kann. Kurz vor dem rückseitigen Ende 26 der Aufnahme des Aufnahmetopfes 19 ist die Zuleitung 36' mit einer Kontaktierung 38' versehen, die über ein Kabel 39 an einen Anschlussstecker 40 führt. Hier ist also der Anschlussstecker 40 nicht am Dreh-Schaltgerät 28 vorgesehen.

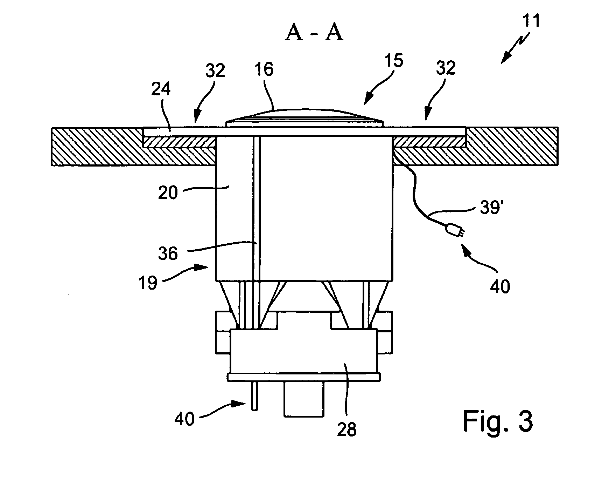

Aus der weiteren Darstellung in Fig. 3 als Schnitt A-A nach Fig. 2 ist zu ersehen, mit welcher Breite eine in Fig. 1 im Schnitt dargestellte elektrische Zuleitung 36 beispielsweise ausgeführt sein kann, und wie sie sich über die Außenseite des Außenmantels 20 erstreckt. Dann geht sie in einen Anschlussstecker 40 an der Unterseite des Dreh-Schaltgeräts 28 über.

Des Weiteren ist in Fig. 3 nur als Alternative ein schematischer Anschluss über ein Kabel 39' an ein Sensorelement 34 eines kapazitiven Berührungsschalters 32 dargestellt. Insbesondere kann es möglich sein, im Falle solcher separater bzw. loser Kabel für alle Sensorelemente 34 einen einzigen Mehrfach-Steckanschluss vorzusehen.

In nochmaliger Ausgestaltung der Erfindung kann, wie aus der zeitgleich eingereichten Patentanmeldung derselben Anmelderin mit dem internen Zeichen P 49315 DE bekannt, der Aufnahmetopf 19, insbesondere der Außenmantel 20, zumindest teilweise aus lichtleitendem Material bestehen. Bei Lichteinstrahlung von hinten, beispielsweise mit LED an Dreh-Schaltgerät 28, können so vorne an dem kragenartigen Abschnitt 24 Leuchteffekte hervorgerufen werden.

Eine elektrisch leitfähige Beschichtung auf dem Aufnahmetopf 19, sei es an der Rückseite des kragenartigen Abschnitts 24 oder der Außenseite des Außenmantels 20, kann beispielsweise durch einen Druckvorgang insbesondere einen Tampondruck, erfolgen.

Aus Fig. 2 ist auch zu ersehen, dass durch Ansteuern zweier nebeneinander liegender Sensorelemente ein kapazitives Überkoppeln bei Auflegen eines Fingers erkannt werden kann. Dies ist eine alternative kapazitive Erkennung.

## Patentansprüche

1. Bedieneinrichtung (11) für ein Elektrogerät mit einer Bedienblende (12) und einem in der Bedienblende angeordneten Bedienelement (15) zur Bedienung durch Drehbetätigung, wobei das Bedienelement in einer topfartigen Aufnahme (19) gelagert ist, wobei in einem Bereich der Bedienblende (12) nahe an dem bzw. um das Bedienelement (15) herum mindestens ein zusätzlicher Berührungsschalter (32) angeordnet ist, wobei eine elektrische Zuleitung (36) bzw. Verbindung zu dem Berührungsschalter bzw. dessen Sensorelement (34) in die Aufnahme (19) des Bedienelements (15) integriert ist, wobei die Aufnahme in einem Durchbruch (13) der Bedienblende (12) angeordnet ist, wobei ein Schaltgerät (28) an einem hinteren Ende der Aufnahme (19) so befestigt ist, dass das Schaltgerät (28) mittels des Bedienelements (15) betätigbar ist, **dadurch gekennzeichnet, dass** die elektrische Zuleitung (36) bzw. Verbindung als elektrisch leitfähige Beschichtung auf einer Oberfläche der Aufnahme (19) vorgesehen ist.

2. Bedieneinrichtung nach Anspruch 1, **dadurch gekennzeichnet, dass** der Berührungsschalter (32) ein kapazitiver Berührungsschalter ist mit einem elektrisch leitfähigen kapazitiven Sensorelement (34), wobei vorzugsweise das Sensorelement nach außen bzw. an der Vorderseite der Bedienblende (12) elektrisch isoliert ist.

3. Bedieneinrichtung nach Anspruch 1 oder 2, **dadurch gekennzeichnet, dass** der Berührungsschalter (32) bzw. dessen Sensorelement (34) an einem kragenartigen Abschnitt (24) der Aufnahme (19) um das Bedienelement (15) herum angeordnet ist, wobei vorzugsweise der kragenartige Abschnitt (24) den Berührungsschalter (32) bzw. dessen Sensorelement (34) überdeckt.

4. Bedieneinrichtung nach Anspruch 2 oder 3, **dadurch gekennzeichnet, dass** das Sensorelement (34') als Beschichtung ausgebildet ist, vorzugsweise als Beschichtung auf einem Bereich der Aufnahme (19), der parallel zur Bedienblende (12) verlaufend ausgebildet ist.

5. Bedieneinrichtung nach Anspruch 2 oder 3, **dadurch gekennzeichnet, dass** das Sensorelement (34) aus Flachmaterial ausgebildet ist, vorzugsweise als flaches Metallplättchen, wobei es insbesondere als separates Teil an der Bedienblende (12) oder an der Aufnahme (19) befestigt ist.

6. Bedieneinrichtung nach Anspruch 1, **dadurch gekennzeichnet, dass** die elektrisch leitfähige Beschichtung als elektrische Zuleitung (36) bzw. Verbindung an der Außenseite der Aufnahme (19) vorgesehen ist.

7. Bedieneinrichtung nach Anspruch 1, **dadurch gekennzeichnet, dass** eine elektrische Verbindung von der elektrischen Zuleitung (36) bzw. Verbindung an der Aufnahme (19) zu einem an dem hinteren Ende der Aufnahme angeordneten Schaltgerät (28) des Bedienelements (15) vorgesehen ist zum elektrischen Anschluss des Berührungsschalters (32) an dem rückwärtigen Ende des Schaltgeräts (28).

8. Bedieneinrichtung nach einem der vorhergehenden Ansprüche, **dadurch gekennzeichnet, dass** mehrere zusätzliche Berührungsschalter (32) an der Bedienblende (12) um das Bedienelement (15) herum vorgesehen sind, wobei vorzugsweise für jeden separaten Berührungsschalter (32) eine separate elektrische Zuleitung (36) bzw. Verbindung vorgesehen ist mit separatem Anschluss (38).

9. Bedieneinrichtung nach einem der vorhergehenden Ansprüche, **dadurch gekennzeichnet, dass** die Bedieneinrichtung (11) in die Bedienblende (12) des Elektrogeräts eingesetzt ist.

10. Bedieneinrichtung nach einem der vorhergehenden Ansprüche, **dadurch gekennzeichnet, dass** um das Bedienelement (15) herum eine Anzeige vorgesehen ist, insbesondere eine OLED-Anzeige mit unterschiedlicher Ansteuerung.

## Claims

1. An operating device (11) for an electrical appliance with a control panel (12) and an operating element (15) arranged in the control panel for operation by rotary actuation, the operating element being mounted in a cup-like receptacle (19), wherein at least one additional touch-sensitive switch (32) is arranged in a region of the control panel (12) close to or around the operating element (15), wherein an electrical supply lead (36) or connection to the touch-sensitive switch or the sensor element (34) thereof is incorporated into the receptacle (19) of the operating element (15), wherein the receptacle is arranged in an aperture (13) of the operating element (12), wherein a switching device (28) is attached at a rear end of the receptacle (19) in such a way that the switching device (28) is to be actuated by means of an operating element (15), **characterized in that** the electrical supply lead (36) or connection is provided as an electrically conductive coating on a surface of the receptacle (19).

2. The operating device according to claim 1, **characterized in that** the touch-sensitive switch (32) is a capacitive touch-sensitive switch with an electrically conductive capacitive sensor element (34), wherein preferably the sensor element is electrically insulated to the outside or on the front of the control panel (12).

3. The operating device according to claim 1 or 2, **characterized in that** the touch-sensitive switch (32) or the sensor element (34) thereof is arranged on a collar-like portion (24) of the receptacle (19) around the operating element (15), wherein preferably the collar-like portion (24) covers the touch-sensitive switch (32) or the sensor element (34) thereof.

4. The operating device according to claim 2 or 3, **characterized in that** the sensor element (34') is configured as a coating, preferably as a coating on a region of the receptacle (19) extending parallel to the control panel (12).

5. The operating device according to claim 2 or 3, **characterized in that** the sensor element (34) takes the form of flat material, preferably the form of a flat metal plate, wherein in particular said plate is attached as a separate part to the control panel (12) or to the receptacle (19).

6. The operating device according to claim 1, **characterized in that** the electrically conductive coating is provided to be an electrical supply lead (36) or a connection on the outside of the receptacle (19).

7. The operating device according to claim 1, **characterized in that** an electrical connection from the electrical supply lead (36) or connection at the receptacle (19) to a switching device (28) arranged at the rear end of the receptacle of the operating element (15) is provided for electrical connection of the touch-sensitive switch (32) at the rearward end of the switching device (28).

8. The operating device according to any of the preceding claims, **characterized in that** a plurality of additional touch-sensitive switches (32) are provided on the control panel (12) around the operating element (15), wherein preferably a separate electrical supply lead (36) or connection with a separate terminal (38) being provided for each separate touch-sensitive switch (32).

9. The operating device according to any of the preceding claims, **characterized in that** the operating device (11) is inserted into the control panel (12) of the electrical appliance.

10. The operating device according to any of the preceding claims, **characterized in that** a display is provided around the operating element (15), in particular an OLED display with different activation.

## Revendications

1. Dispositif de commande (11) d'un appareil électrique comprenant un panneau de commande (12) et un élément de commande (15) disposé dans le panneau de commande pour effectuer la commande par un actionnement par rotation, l'élément de commande étant monté dans un logement (19) de type pot, au moins un commutateur tactile supplémentaire (32) étant disposé dans une région du panneau de commande (12) à proximité de l'élément de commande (15) ou autour de celui-ci, une ligne d'alimentation électrique (36) ou une connexion au commutateur tactile ou à son élément de capteur (34) étant intégrée dans le logement (19) de l'élément de commande (15), le logement étant disposé dans un orifice (13) du panneau de commande (12), un appareil de commutation (28) étant fixé sur une extrémité arrière du logement (19) de telle sorte que l'appareil de commutation (28) puisse être actionné au moyen de l'élément de commande (15), **caractérisé en ce que** la ligne d'alimentation électrique (36) ou la connexion est prévue sous forme de revêtement électriquement conducteur sur une surface du logement (19).

2. Dispositif de commande selon la revendication 1, **caractérisé en ce que** le commutateur tactile (32) est un commutateur tactile capacitif avec un élément de capteur (34) capacitif électriquement conducteur, l'élément de capteur étant de préférence isolé électriquement vers l'extérieur ou sur le côté avant du panneau de commande (12).

3. Dispositif de commande selon la revendication 1 ou 2, **caractérisé en ce que** le commutateur tactile (32) ou son élément de capteur (34) est disposé sur une portion (24) de type collerette du logement (19) autour de l'élément de commande (15), la portion (24) de type collerette recouvrant de préférence le commutateur tactile (32) ou son élément de capteur (34).

4. Dispositif de commande selon la revendication 2 ou 3, **caractérisé en ce que** l'élément de capteur (34') est réalisé sous forme de revêtement, de préférence sous forme de revêtement sur une région du logement (19) qui est réalisée de manière à s'étendre parallèlement au panneau de commande (12).

5. Dispositif de commande selon la revendication 2 ou 3, **caractérisé en ce que** l'élément de capteur (34) est réalisé sous forme de matériau plan, de préférence sous forme de plaquette métallique plane, et est fixé notamment sous forme de pièce séparée sur le panneau de commande (12) ou sur le logement (19).

6. Dispositif de commande selon la revendication 1, **caractérisé en ce que** le revêtement électriquement conducteur est prévu sous forme de ligne d'alimentation électrique (36) ou de connexion sur le côté extérieur du logement (19).

7. Dispositif de commande selon la revendication 1, **caractérisé en ce qu'**une connexion électrique est prévue depuis la ligne d'alimentation électrique (36) ou la connexion sur le logement (19) jusqu'à un appareil de commutation (28) de l'élément de commande (15), disposé sur l'extrémité arrière du logement, pour le raccordement électrique du commutateur tactile (32) à l'extrémité arrière de l'appareil de commutation (28).

8. Dispositif de commande selon l'une quelconque des revendications précédentes, **caractérisé en ce que** plusieurs commutateurs tactiles supplémentaires (32) sont prévus sur le panneau de commande (12) autour de l'élément de commande (15), une ligne d'alimentation électrique (36) séparée ou une connexion étant de préférence prévue pour chaque commutateur tactile séparé (32), avec un raccordement séparé (38).

9. Dispositif de commande selon l'une quelconque des revendications précédentes, **caractérisé en ce que** le dispositif de commande (11) est inséré dans le panneau de commande (12) de l'appareil électrique.

10. Dispositif de commande selon l'une quelconque des revendications précédentes, **caractérisé en ce qu'**un affichage est prévu autour de l'élément de commande (15), notamment un affichage OLED, avec une commande différente.
